# EUROPEAN PATENT APPLICATION

(11) **EP 2 333 476 A1**
(43) Date of publication of application: **15.06.2011**
(21) Application number: 09800340.3
(22) Date of filing: 14.07.2009
(51) Int. Cl.: F28F 13/12, B21D 22/02, B21D 53/04, F28F 13/08, H01L 23/473

(54) **HEAT EXCHANGER AND METHOD OF MANUFACTURING SAME**

(30) Priority: 24.07.2008 JP 2008190946
(71) Applicant: Toyota Jidosha Kabushiki Kaisha, Toyota-shi, Aichi 471-8571 (JP)
(72) Inventor: MORINO Masahiro, Toyota-shi Aichi 471-8571 (JP); TAKETSUNA Yasuji, Toyota-shi Aichi 471-8571 (JP); INOSHITA Hirofumi, Toyota-shi Aichi 471-8571 (JP); MATSUI Hirohito, Nishio-shi Aichi 445-0012 (JP)
(74) Representative: Albutt, Anthony John
(86) International application number: PCT/JP2009/062701
(87) International publication number: WO 2010/010826

(57) **Abstract**

Provided are a heat exchanger having a novel structure and efficiently cooling a heat generating body, and a method of manufacturing the heat exchanger. A heat exchanger (1) has flow paths (3) formed by being closed by an upper plate (14) and a lower plate (12) which have rectilinearly formed upstanding fins (11) parallelly arranged at specific intervals, and gaps extend between adjacent fins (11) in the top-bottom direction along the direction in which the fins (11) extend. Either of or both the upper plate (14) and the lower plate (12) are provided with projections (23) arranged in the longitudinal direction of the flow path (3) and projecting inward of the flow path (3).

## Description

### Technical Field

The present invention relates to a heat exchanger provided with passages defined by a plurality of straight fins arranged in parallel, the heat exchanger being configured to allow a refrigerant or cooling medium to pass through the passages to thereby dissipate heat from a heating element. Particularly, the invention relates to a heat exchanger in which passages for allowing a refrigerant to pass are formed to enhance heat dissipation effect and a method of manufacturing the heat exchanger.

### Background Art

Hybrid electric vehicles or the like incorporate a semiconductor device in an inverter to drive a motor, and a water-cooling heat exchanger is adopted for cooling the semiconductor device. With respect to the inverter mounting the semiconductor device, higher output power has been desired while a reduction in size and weight also has been demanded increasingly. Accordingly, a demand for a heat exchanger excellent in a heat dissipation effect has been increased. Patent Literature 1 described below discloses a conventional heat exchanger having improved cooling performance. FIG. 16 is a sectional view of a heat exchanger of Patent Literature 1 in a plan view.

A heat exchanger 100 includes a case 101 provided with a supply port 102 and a discharge port 103. In the case 101, passages (flow paths) are formed to allow a refrigerant to pass from the supply port 102 to the discharge port 103. In this heat exchanger 100, the passages are defined by a plurality of fins 111 and the passages are divided into three in the linear direction; first, second, and third fin groups 201, 202, and 203. Each of the fin groups 201 to 203 includes a plurality of the fins 111 arranged in parallel with the lateral direction. The fins 111 of each fin group 201 to 203 are arranged in alignment with those of the adjacent fin groups to form a plurality of straight passages. The straight flow passages are however interrupted in between the fin groups 201, 202, and 203 and merging sections 105 and 106 are formed there.

Further, the heat exchanger 100 is provided with separating fins 112 placed between the laterally extending fins 111 to form a wide passage 107 wider than the passages defined between the fins 111. In the third fin group 203, two adjacent separating fins 112 are connected to close one end of the passage 107. Then, in this heat exchanger 100, semiconductor devices serving as heating elements are placed respectively in nine sections partitioned by the merging sections 105 and 106 and the separated passage 107 defined by the separating fins 112. To be specific, in the heat exchanger 100, the refrigerant taken into the exchanger 100 from the supply port 102 passes through the linear passages formed between the fins 111. Multiple refrigerant flows join together at the merging sections 105 and 106 to equalize flow distribution and then diverge into downstream passages.

### Citation List

### Patent Literature

Patent Literature 1: JP2007-335588A

### Summary of Invention

### Technical Problem

When the passages defined by the fins are straight as in the heat exchanger 100, the refrigerant is apt to flow in laminar flow. Therefore, while the refrigerant flows fast in the central portion of each passage, the flow is slow in boundary layers or areas where the refrigerant contacts with the fins 111. As a result, the heat of each heating element transferred to the fins is hard to be dissipated, interfering enhancement of the cooling performance. With regard to this point, an effective way to efficiently dissipate the heat from the fins by the refrigerant is to break the boundary layers by disturbing the flow of the refrigerant. However, traversing passages like the merging sections 105 and 106 in the heat exchanger 100 are not enough to achieve the above effect.

In recent years, a semiconductor device tends to have larger heat generating density because of its reduced size. This leads to a demand for improvement of the cooling performance of the heat exchanger to be used in an inverter or the like. In response to that, the heat exchanger in which the fins are arranged in an offset pattern has been proposed. However, the heat exchanger having such offset fin arrangement requires complicated working, leading to an increase in manufacturing cost. Especially, when the conventional fin member is formed by casting or other methods, a high processing cost is needed, which results in a high cost of the heat exchanger itself. Further, such fin member is hard to finely machine and thus the improvement of cooling performance could not be achieved.

The present invention has been made to solve the above problems and has a purpose to provide a heat exchanger having a novel structure capable of efficiently cooling a heating element and a manufacturing method of the heat exchanger.

### Solution to Problem

According to one aspect of the present invention, there is provided a heat exchanger having a plurality of upstanding fins formed linearly and arranged in parallel with each other at predetermined intervals, and an upper plate and a lower plate placed top and bottom in an upstanding direction of the fins to enclose spaces between the adjacent fins to provide a plurality of passages defined by the enclosed spaces, wherein at least one of the upper and lower plates includes a plurality of protrusions arranged in a longitudinal direction of each passage to protrude therein.
Further, in the above heat exchanger, it is preferable that the heat exchanger has: a fin member including the fins integrally formed on a base constituting either one of the upper and lower plates; and a cover plate constituting the other one of the upper and lower plates which is connected to the fins in an opposite side from the base, wherein the protrusions are formed on either the base or the cover plate.

In the above heat exchanger, preferably, the fin member is formed by extrusion-molding.
In the above heat exchanger, preferably, the protrusions are formed by press working.
In the above heat exchanger, preferably, ones of the protrusions adjacently arranged in a longitudinal direction of each passage are placed at such intervals as to prevent cooling performance to be generated between the protrusions from falling below a predetermined reference value.
In the above heat exchanger, preferably, the protrusions formed in the adjacent passages are arranged in a staggered pattern in a direction perpendicular to the passages.

According to another aspect of the invention, there is provided a method for manufacturing a heat exchanger including a plurality of upstanding fins formed linearly and arranged in parallel with each other at predetermined intervals and an upper plate and a lower plate placed top and bottom in an upstanding direction of the fins to enclose spaces between the adjacent fins to provide a plurality of passages defined by the enclosed spaces, wherein the method comprises: a fin member working step of forming a fin member by extrusion-molding, the fin member having a plurality of the fins upstanding vertically on a base constituting one of the upper and lower plates; a protrusion forming step of forming a plurality of the protrusions by pressing on the base of the fin member or on a cover plate constituting the other one of the upper and lower plates; and a bonding step of bonding the cover plate to the fins on an opposite side from the base.

Further, in the above heat exchanger manufacturing method, preferably, the protrusion forming step comprises press-fitting a punch in the base or the cover plate on an opposite side from a passage surface to extrude a material toward the passage surface side.
In the above heat exchanger manufacturing method, preferably, when the protrusions are to be formed in the base in the protrusion forming step, a plate-shaped holding member is inserted in the spaces between the adjacent fins to hold the fins.
In the above heat exchanger manufacturing method, preferably, the fin member working step includes forming a fin member having raised portions each continuous in the extruding direction in each space between the adjacent fins, and the protrusion forming step includes inserting pressing plates separately formed in the extruding direction into the spaces to squash the raised portions except separating portions to form the protrusions.

### Advantageous Effects of Invention

According to a heat exchanger of the invention, a refrigerant flowing through passages is disturbed its flow by protrusions so that boundary layers contacting with fins are broken, and thereby the refrigerant deriving heat from the fins smoothly flows downstream without causing stagnation. Accordingly, the cooling performance is enhanced. Therefore, even when the heat generating density has been increased due to a small-sized heating element, the heating element can be cooled compared to the conventional one because the cooling performance has been improved. Further, the heat exchanger of the invention is simply configured in a manner that passages defined by straight fins are provided with protrusions, simplifying its structure and working and leading to cost reduction in manufacturing operation. In particular, the heat exchanger in the invention is manufactured by applying a fin member formed by extrusion-molding and a base and a cover plate formed with protrusions by pressing, so that mass production of the heat exchanger is achieved, capable of supplying the heat exchanger at low cost.

### Brief Description of Drawings

FIG. 1 is a perspective view of a heat exchanger according to an embodiment;
FIG. 2 is a perspective view of the heat exchanger from which a holding frame is removed;
FIG. 3 is a perspective view of a fin member of the heat exchanger;
FIG. 4 is a diagram showing a flow of a refrigerant flowing inside a passage of the heat exchanger;
FIG. 5 is a graph showing a result of a cooling performance test conducted by flowing the refrigerant inside the passage of the heat exchanger;
FIG. 6. is a perspective view of the heat exchanger in use state;
FIG. 7 is a conceptual view showing one step of a working process to form the fin member for the heat exchanger;
FIG. 8 is a sectional view of a press device for forming protrusions;
FIG. 9 is a perspective view of a heat exchanger from which a holding frame is removed in another embodiment;
FIG. 10 is a simplified diagram showing a working process of forming protrusions in the fin member shown in FIG. 9;
FIG. 11 is a plan view showing one example of arrangement of the protrusions in the passages;
FIG. 12 is a sectional view of a press device for forming protrusions;
FIG. 13 is a perspective view showing a method of forming the protrusions by pressing;
FIG. 14 is a sectional view of the fin member immediately after the extrusion-molding before the protrusions are to be formed as shown in FIG. 13;
FIG. 15 is a perspective view of the fin member formed with the protrusions formed by the method shown in FIG. 13; and

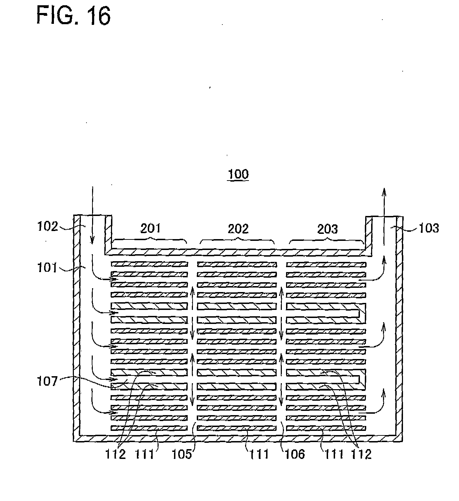

FIG. 16 is a planar sectional view of a conventional heat exchanger.

### Description of Embodiments

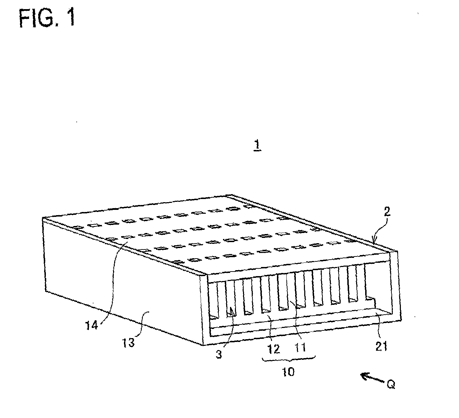

A detailed description of a preferred embodiment of a heat exchanger and a method of manufacturing the same embodying the present invention will now be given referring to the accompanying drawings. FIG. 1 is a perspective view showing a heat exchanger of the present embodiment.
A heat exchanger 1 includes a plurality of fins 11 arranged in a main body 2 formed in a rectangular tubular shape. The main body 2 has an inlet-side opening 21 and an outlet-side opening which open at both ends to form a plurality of passages 3. In the main body 2 of the heat exchanger 1, a refrigerant is allowed to flow in a direction indicated by an arrow Q in the figure, thus the passages 3 extend through from the inlet-side opening 21 to the outlet-side opening.

In the heat exchanger 1 shown in FIG. 1, the inlet-side opening 21 and the outlet-side opening largely open on either side of the main body 2. During use, on the other hand, the inlet-side opening 21 and the outlet-side opening are closed and connected respectively to a refrigerant supply pipe or a refrigerant discharge pipe, both of which are not shown. The refrigerant supply pipe is connected to a supply pump for pumping a refrigerant at a constant pressure to the heat exchanger 1 and the refrigerant discharge pipe is connected to a tank for collecting the refrigerant discharged from the heat exchanger 1.

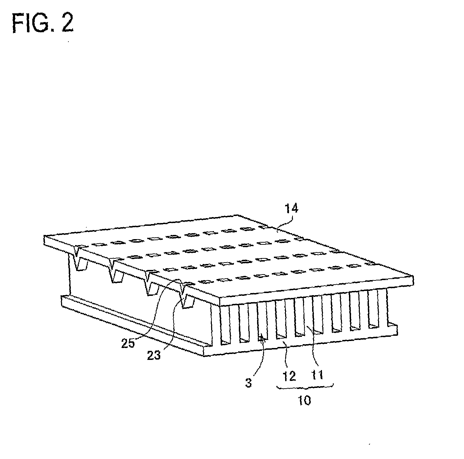

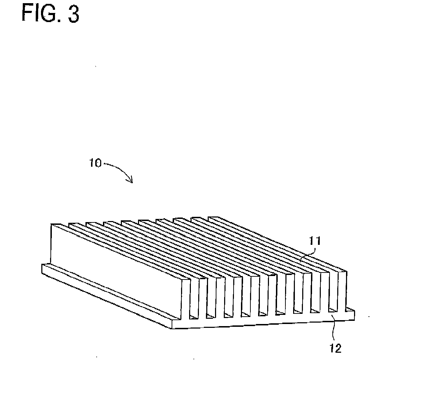

The heat exchanger 1 includes a holding frame 13 having a U-shaped cross section and an upper opening and a cover plate 14 fitted on that opening, forming the tubular-shaped main body 2. A fin member 10 is incorporated in the main body 2 to form the plurality of passages 3. Herein, FIG. 2 is a perspective view of the heat exchanger 1 of FIG. 1 from which the holding frame 13 is removed and FIG. 3 is a perspective view of the fin member 10 from which the cover plate 14 is removed.

The fin member 10 is integrally formed with the plurality of fins 11 protruding from a base 12. The base 12 is a rectangular flat plate and formed with the fins 11 upstanding therefrom in a perpendicular direction to the base 12. The fins 11 have the same height with each other and the same length with the base 12 in a longitudinal direction. The adjacent fins 11 are arranged in parallel with one another. The thus configured fin member 10 is inserted in the holding frame 13 without backlash and the cover plate 14 is placed on the holding frame 13 so that the plate 14 abuts on tips of the fins 11. The heat exchanger 1 is integrally configured by welding the fin member 10 mounted in the holding frame 13, the holding frame 13, and the cover plate 14.

In the heat exchanger 1, spaces between the adjacent fins 11 are enclosed by the base 12 as a lower plate and the cover plate 14 as an upper plate to define the passages 3 arranged in parallel. The fins 11 at both end sides of the fin member 10 form spaces from the upstanding wall plates of the flame 13, the spaces being enclosed by the base 12 and the cover plate 14 to form the passages 3.

When the refrigerant flows through the inlet-side opening 21 to the main body 2 in the direction Q in FIG.1, the refrigerant branches off to the passages 3 partitioned by the fins 11. In the heat exchanger 1 of the present embodiment, the passages 3 defined by the fins 11 are straight paths and therefore the refrigerant tends to flow in laminar flow as same as the conventional technique, resulting in poor cooling performance. Accordingly, the heat exchanger 1 of the embodiment is provided with a configuration to disturb the refrigerant flow. Specifically, the cover plate 14 defining the passages 3 is formed with protrusions 23 serving as obstacles to the refrigerant flowing through the passages 3.

The protrusions 23 are provided on an opposite side of recesses 25 formed on one side of the cover plate 14 in the thickness direction as shown in FIG. 2, each protrusion 23 being spaced at a predetermined interval from each other in the vertical and lateral directions. To be more concrete, the protrusions 23 are provided to be insertable in the spaces between the adjacent fins 11 so that the protrusions are present at fixed intervals in each passage 3 when the cover plate 14 is set to assemble the heat exchanger 1 as shown in FIG. 1.

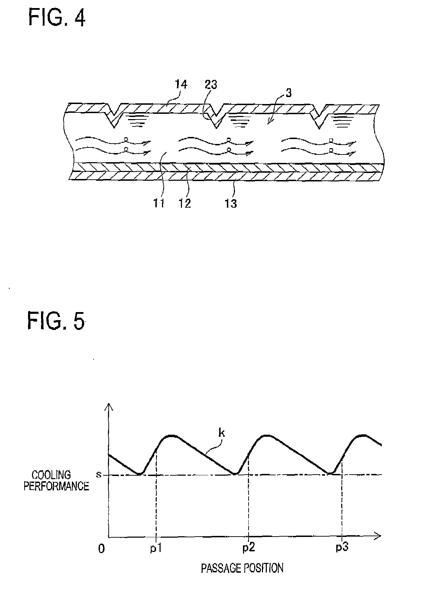

FIG. 4 is a diagram showing the flow of the refrigerant inside the passage 3. Since the passage 3 defined by the fins 11 is linearly formed, the flow of the refrigerant could be a laminar flow, leading to the same problem with the conventional technique if the passage 3 is left as it is. In the present embodiment, therefore, the flow of the refrigerant is disturbed by the existence of the protrusions 23 to break a boundary layer contacting with the fins 11 generated in the laminar flow, thereby efficiently dissipating heat of the fins 11.

Further, especially in the heat exchanger 1 of the present embodiment, the protrusions 23 are placed at the specific intervals inside each passage 3 to maintain the cooling performance. FIG. 5 is a graph showing a result of a cooling performance test conducted by flowing the refrigerant in the passage 3. The horizontal axis of the graph indicates specific positions taken out from an arbitrary part of the passage 3 and the vertical axis indicates the cooling performance (heat transfer coefficient). Passage points p1, p2, and p3 in the horizontal axis represent the positions in which the protrusions 23 are formed, and the refrigerant flows in the direction from the point p1 to the point p3.

The graph of FIG. 5 shows that the cooling performance of the refrigerant flowing through the passage 3 is not constant but changes like a waveform. In other words, the heat transfer coefficient differs from position to position in the passage. Especially, in the graph k, the cooling performance goes up toward each of the points p1, p2, and p3 representing the existence of the protrusions 23 and reaches at peak immediately after each of the points p1, p2, and p3 and then the graph gradually goes down. This is because the flow of the refrigerant is disturbed by the protrusions 23 and the refrigerant flows to efficiently remove the heat from the fins 11. On the other hand, the graph goes down thereafter. This is conceivably because the flow of the refrigerant returns to the laminar flow as it comes away from the protrusions 23, so that the flow of the boundary layer contacting with the fins 11 tends to be stagnant.

In response to this, in the present embodiment, the cooling performance required to dissipate heat of the heating element is set to be a reference value "s" and the position of each protrusion 23 is determined in a manner that the heat transfer coefficient would not fall below the reference value "s". Specifically, the distance between the protrusions 23 arranged in the longitudinal direction of the passage 3 is determined so that the heat transfer coefficient indicated with the graph k goes up just before the graph falls below the reference value "s". The distance between the protrusions 23 differs depending on a size of the passage 3, a flow rate of the refrigerant to be supplied, the height of the protrusions 23, a heat generating amount of the heating elements, and others. Further, since the protrusions 23 also serve to interfere with the flow of the refrigerant to cause pressure increase, the height of each protrusion 23 in the present embodiment is determined to be one third of the passage 3, taking into account of the capability of the supply pump and others.

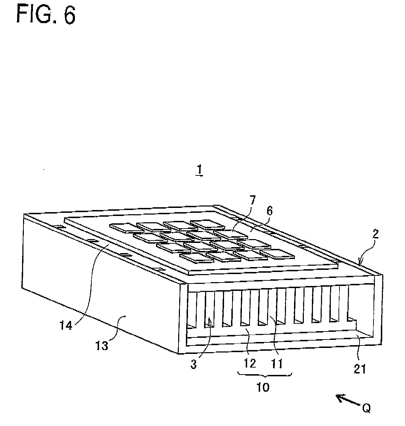

In the heat exchanger 1 in use, as shown in FIG. 6 for example, a heat spreader 6 for thermal diffusion is placed on the cover plate 14 and semiconductor devices 7 serving as heating elements are orderly arranged on the heat spreader 6. When the semiconductor devices 7 used for an inverter or the like generate heat, the heat is transferred to the heat spreader 6 and diffused to be further transferred through the main body 2 to the fins 11. In the main body 2, the refrigerant is supplied from the inlet-side opening 21 and flows toward the outlet-side opening in the opposite side of the main body 2. As a result, the heat transferred to the fins 11 is taken away by the refrigerant flowing in contact with the fins 11, so that heat dissipation is carried out.

The refrigerant flowing in each passage 3 is disturbed in flow by the protrusions 23 to break the boundary layers contacting with the fins 11. Since the protrusions 23 are arranged with predetermined intervals, the refrigerant is caused to flow in each passage 3 while being constantly agitated. Thus, the refrigerant having removed the heat efficiently flows downstream. Especially, the cooling performance is maintained equal to or higher than the reference value "s" in FIG. 5.
Even when the semiconductor devices are downsized, having a larger heat generating density, the heat exchanger 1 with extremely enhanced cooling performance compared to the conventional ones can cool such semiconductor devices. Further, the heat exchanger 1 has such a simple configuration of only providing the protrusions 23 in each passage 3 defined by the fins 11 that less number of components are required, thereby enabling cost reduction.

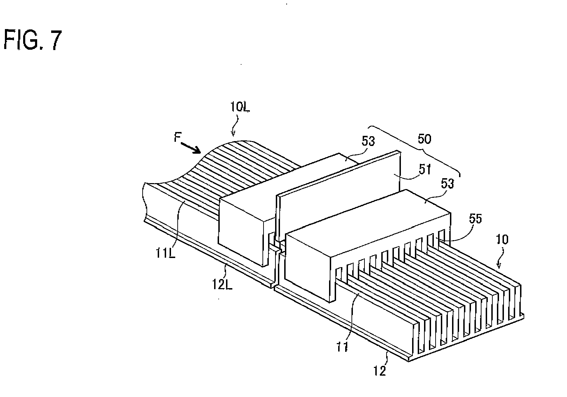

The present embodiment realizes reducing the working cost for manufacturing the heat exchanger 1 having the excellent cooling performance, and thereby providing the heat exchanger 1 at low cost. The manufacturing method of such heat exchanger 1 is now explained.
First, the fin member 10 for the heat exchanger 1 is formed by extrusion-molding. A material used herein for the fin member 10 is aluminum having a good heat transfer coefficient. The molten material is extruded from a molding die for integrally forming the plurality of fins 11 and the base 12, and a long-fin member having a several meters length is formed, for example. FIG. 7 is a conceptual view of a part of a working process to form the fin member 10.

An extruded long-fin member 10L is directly transferred to and cut by a press device shown in the figure after the extrusion-molding. The long-fin member 10L is integrally formed with a long base 12L and long fins 11L vertically upstanding from the long base 12L. Thereafter, the long-fin member 10L is transferred in the extruding direction F as shown in the figure. The long-fin member 10L just extruded remains soft because a material forming the long-fin member 10L is heated to some extent. Such long-fin member 10L is further forwarded to and cut by a press device 50 for cutting.

The cutting press device 50 includes a not-shown lower die for supporting a bottom part of the long base 12L and a plate-shaped upper die 51 placed perpendicularly to the extrusion direction F to be movable vertically downward with respect to the lower die. The upper die 51 is a flat plate having a uniform thickness and a flat bottom end surface. Further, a pair of fin holding jigs 53 is provided on both sides of the upper die 51 to prevent the fins 11 from buckling and falling down due to the pressing force of the upper die 51. Each of the fin holding jigs 53 is formed with a plurality of flat plate-shaped supporting teeth 55 to be inserted individually in the spaces between the adjacent fins 11.

The conveyance of the extruded long-fin member 10L is once. Then, the supporting teeth 55 of the fin holding jigs 53 are individually inserted in the spaces between the adjacent long fins 11L of the long-fin member 10L to support every single long fin 11 L from both sides. Subsequently, the upper die 51 comes down to a space between the pair of fin holding jigs 53 to cut off the long fins 11L at one time. At the same time, the long base 12L is also cut off on the same cutting line with the long fins 11. In this cutting process, the long fin member 10L of long length is cut off at predetermined pitches, so that the plurality of fin members 10 is successively produced. In addition, the holding frame 13 is also formed by extrusion-molding and cutting as similar to the above method.

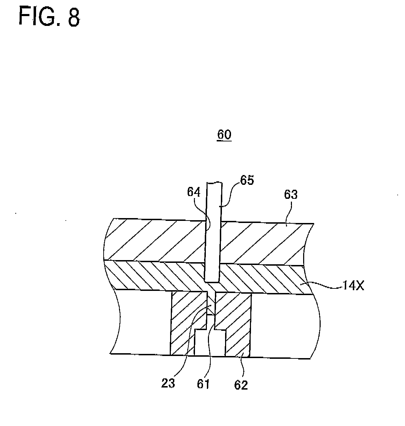

A working or machining method for forming the cover plate 14 is now explained. The cover plate 14 is produced in such a way that a flat plate of a predetermined size is cut off from an aluminum plate having a uniform thickness and formed with the protrusions 23 in predetermined positions. The protrusions 23 are formed in the flat plate by press working. FIG. 8 is a sectional view of a press device for forming protrusions.
Each protrusion 23 of the heat exchanger 1 is of a triangular shape, but the shape of the protrusion is not limited thereto as long as the protrusion can perform the same function as the protrusion 23. Though FIG. 8 shows a press device for forming protrusions of cylindrical shape, the explanation of the pressing method is given regarding the protrusions as same as the protrusions 23 in FIG. 2.

In a press device 60 for forming protrusions, a lower receiving base for holding a flat plate 14X is formed with a die 62. This die 62 is formed with a die hole 61 of circular shape in cross section. On the other side, an upper pressing base is provided with a stopper 63 for holding down the flat plate 14X by use of a not-shown spring and the stopper 63 is formed with a guiding through hole 64 in which a tubular-shaped punch 65 is inserted. A diameter of the punch 65 is designed to be wider than that of the die hole 61. FIG. 8 shows a partial configuration for forming one protrusion 23, but the press device 60 as a whole includes a plurality of identical configurations to that shown in FIG. 8 to form a predetermined number of protrusions 23 in the flat plate 14X at one time.

In a protrusion forming process, the flat plate 14X is held in place between the die 62 and the stopper 63 and thereafter the punch 65 in the guiding through hole 64 is press-fitted in the flat plate 14X. At that time, the punch 65 is press-fitted to the halfway of the flat plate 14X without penetrating through the flat plate 14X. In the vicinity of the press-fitted region of the flat plate 14X, a material of the surface of the flat plate 14X is drawn by the punch 65, but displacement of the flat plate 14X can be prevented by the stopper 63 to maintain the planar surface to some extent. In the opposite side of the flat plate 14X from the punch 65, on the other hand, the material of the flat plate 14X is extruded into the die hole 61 to form a columnar shaped protrusion 23. With respect to the flat plate 14X, a predetermined number of the protrusions 23 are formed by pressing. Thus the cover plate 14 is formed in one working operation.

According to the manufacturing method of the heat exchanger in the present embodiment, the fin member 10 is formed by cutting the long-fin member 10L by use of the press device 50 immediately after the long-fin member 10L is extrusion-molded. Therefore, a large number of the fin members 10 can be produced in a short time compared to other methods such as casting. In particular, the material is cut immediately after the extrusion-molding while the material is still soft, so that the re-heating process can be omitted, thus shortening the working time. Further, as for the cover plate 14, the protrusions 23 are formed by press working of the flat plate 14X by use of the press device 60, so that the working operation is simplified and working time is shortened, enabling mass production of the cover plate 14. This can reduce costs for components of the heat exchanger 1 and hence provide the heat exchanger 1 itself at low cost.

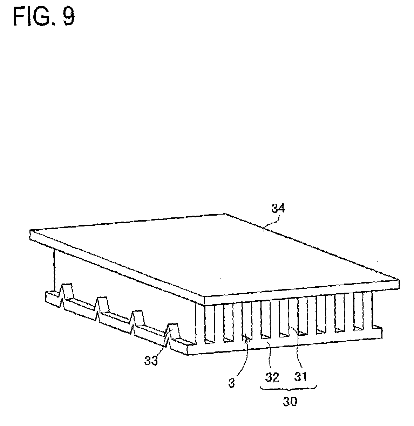

An explanation is given for modifications of the above embodiment of the heat exchanger and the manufacturing method thereof.
In the heat exchanger 1 of the above embodiment, the protrusions 23 are formed in the cover plate 14. Alternately, protrusions 33 may be formed in a fin member 30 as shown in FIG. 9. FIG. 9 is a perspective view of a heat exchanger having the same configuration with the heat exchanger in FIG. 1 from which the holding frame 13 is removed. In this modification, a heat exchanger is configured such that the fin member 30 and a cover plate 34 are attached to the holding frame 13 shown in FIG. 1.

The fin member 30 is integrally formed with a plurality of fins 31 perpendicularly formed on a base 32. The protrusions 33 are arranged in spaces between fins 31 arranged in parallel with each other at predetermined intervals. The protrusions 33 shown in the figure are placed in a passage formed in the space between one fin 31 and the holding frame 13. A plurality of the protrusions 33 are formed in each passage 3 in the longitudinal direction thereof at predetermined intervals to maintain the cooling performance at the reference value "s" as shown in FIG. 5. On the other hand, the cover plate 34 in this modification is a flat plate. However, the cover plate 34 may also be formed with protrusions to provide a heat exchanger having protrusions on both upper and lower sides of each passage 3. Further excellent cooling performance can be expected if the protrusions in each passage 3 are displaced alternately, or staggered, between an upper side and a lower side.

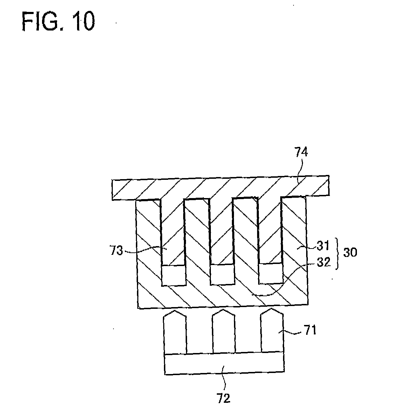

A method of manufacturing a heat exchanger, especially a step of working or machining the fin member 30 having the protrusions 33 is now explained. FIG. 10 is a diagram showing a working step of forming the protrusions 33 of the fin member 30 shown in a simplified manner. The fin member 30 is formed as with the fin member 10 which is cut out from the long-fin member 10L as shown in FIG. 7. Thereafter, the fin member 30 is further subjected to a pressing step for forming protrusions, in which the protrusions 33 are formed in the base 32.

A press device for forming a protrusion includes a pressing die 72 and a receiving die 74. The pressing die 72 includes a plurality of punches 71 to be placed under the base 32 and the receiving die 74 is to receive pressing load. The receiving die 74 is formed with a plurality of supporting projections 73 arranged corresponding to the spaces between the fins 31 so as to prevent the fins 31 from buckling and falling down due to the load applied by the pressing die 72. Each fin 31 of the fin member 30 is inserted in each space between the supporting projections 73 so that a tip of the fin 31 abuts on the receiving die 74 and is thereby supported. With respect to the supported fin member 30, the punches 71 of the pressing die 72 are held against the base 32 and the material deformed by press-fitting of the punches 71 is extruded into the spaces between the fins 31 to form the protrusions 33 in the base 32.

In the heat exchanger 1 in FIG. 1, the protrusions 23 are arranged along each of the passages 3 (see FIG. 2) and further the protrusions 23 are arranged in rows in the direction perpendicular to the passages 3. In this case, if a distance between the adjacent fins 11 is set shorter in order to enhance the cooling performance, a distance between the adjacent protrusions 23 could also be shorter. As a result, the adjacent punches could interfere with each other because the punches for forming the protrusions 23 are larger than the protrusions 23 in size. Further, the shorter distance between the adjacent protrusions 23 causes deterioration of flatness of the cover plate 14. For instance, when the protrusions 23 are to be formed in the cover plate 14 as shown in FIG. 2, the material around each recess 25 is drawn by press-fitting of the punches, generating some dents. Consequently, the dents around the recess 25 could be overlapped to enlarge deformation of the material if the distance between the adjacent recesses 25 is short.

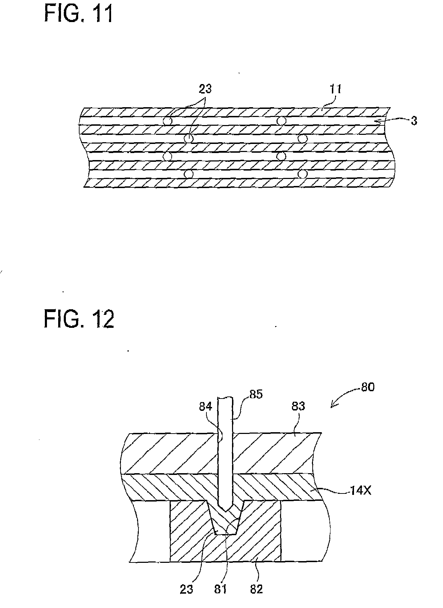

In the case where the distance between the fins 11 is made shorter, the protrusions 23 are arranged in a staggered pattern in the direction perpendicular to the fins 11, as shown in FIG. 11. Thereby, the distance between the adjacent protrusions 23 is increased and the interference of the punches can be avoided. It is thus possible to provide a heat exchanger with the fins 11 arranged at narrow distances from each other to enhance the cooling performance. Furthermore, as well as the protrusions 23, the distance between the adjacent recesses 25 is wider, so that deterioration of the flatness can be prevented. Incidentally, an insulating sheet is bonded to a surface on which the recesses 25 are to be formed, and the flatness therefor is assured.

Working for forming the protrusions provided in each passage is now explained. The press device for protrusions is disclosed in FIG. 8 for processing the protrusions, but alternately, an extrusion-molding type of a press device shown in FIG. 12 may be adopted. A press device 80 for forming a protrusion includes a die 82 in a receiving base to be placed under the flat plate 14X and the die 82 is formed with a recess 81 conforming to the shape of the protrusion to be formed. In a pressing base on the upper side, a stopper 83 for holding down the flat plate 14X by use of a not-shown spring is provided. The stopper 83 is formed with a guiding through hole 84 penetrating through the stopper 83, and a columnar-shaped punch 85 having an acute-angled tip is inserted in the hole 84.

The device of the present embodiment including the punch 85 smaller in diameter than the recess 81 is used to form the relatively large protrusions 23. On the contrary, the press device 60 in FIG. 8 is suitable for forming relatively small-sized protrusions. FIG. 12 shows only a partial configuration of the press device 80 to from one protrusion 23, but the press device 80 is provided with a plurality of identical configurations to that shown in FIG. 12 to form a predetermined number of the protrusions 23 in the flat plate 14X at one time. Even though the protrusion formed by the press device 80 in FIG. 12 is of trapezoidal shape, which is different from the shape of the protrusion in FIG. 2, it is also herein referred to as a protrusion 23.

In the press device 80, the flat plate 14X is held between and positioned by the die 82 and the stopper 83. Thereafter, the punch 85 in the guiding through hole 84 is press-fitted in the flat plate 14X. The punch 85 is pressed into the flat plate 14X until the tip of the punch 85 reaches the recess 81. At this time, in the vicinity of the pressing region, the surface material of the flat plate 14X is drawn by the punch 85, but the stopper 83 restricts displacement of the plate and the flatness is maintained to some extent. On the opposite side of the flat plate 14X, the material is extruded into the recess 81, thereby forming the trapezoidal-shaped protrusion 23. With respect to the flat plate 14X, a predetermined number of the protrusions 23 are formed by the press working, so that manufacturing of the cover plate 14 is completed in a single working.

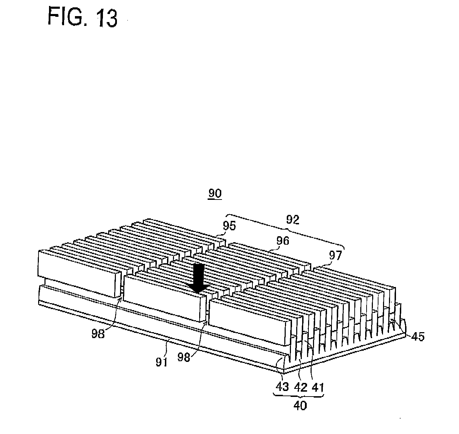

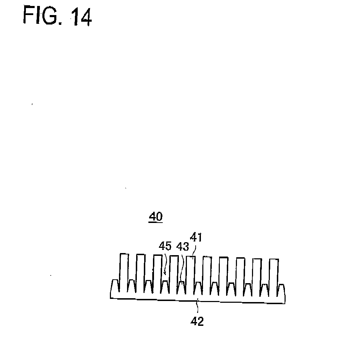

The explanation is now given for a working method of forming extrusions by pressing referring to FIG. 13. In the present modification, a long-fin member is formed by extrusion-molding and then a fin member of a predetermined length is cut off from the long-fin member. Further, the protrusions are formed in the fin member by pressing as shown in FIG. 13. A fin member 40 extrusion-molded in the present modification has a sectional shape in the longitudinal direction as shown in FIG. 14. Specifically, fin members 41 are arranged perpendicularly protruding from a base 42 at predetermined pitches and raised portion43 of trapezoidal shape in section are formed between the fins 41 which define passages. Each raised portion 43 is formed in continuous shape in the longitudinal direction as same as the fins 41.

A press device 90 for forming protrusions includes a lower die 91 for supporting the fin member 40 from the bottom side and an upper die 92 for shaping protrusions. The upper die 92 includes pressing plates 95, 96, and 97 each inserted in a clearance 45 between the fins 41. One set of the pressing plates 95, 96, and 97 are placed linearly along the clearance 45 and formed with separating portions 98 in between the plates. A plurality of sets of the pressing plates 95, 96, and 97 are placed to hold each fin 41 from both sides, the sets of plates being arranged in parallel to one another as shown in the figure. In the figure, each pressing plate 95, 96, and 97 is shown in an independent (separated) state, but the plates are configured to integrally transmit a pressing load applied by a single pressurizing device.

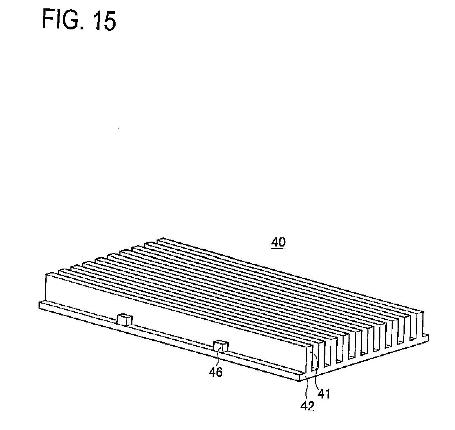

The press device 90 is configured to move the upper die 92 downward to the fin member 40 having the sectional view in FIG. 14 so that the pressing plates 95, 69, and 97 are inserted in the clearances 45 to hold the fins 41. The upper die 92 continues to move down to squeeze or squash the raised portion 43 pressurized by the plates 95, 96, and 97. At this time, the portions of the fins 41 located in the separating portions 98 between the plates 95, 96, and 97 are not squashed, so that protrusions 46 are formed as shown in FIG. 15.
Therefore, according to the manufacturing method of the present embodiment, the protrusions 46 can be formed by use of a simple die without requiring a processing device having a complicated die for forming protrusions. Accordingly, a cost for a processing device can be reduced, leading to cost reduction in processing a heat exchanger.

While the presently preferred embodiment of the heat exchanger and the manufacturing method thereof according to the present invention has been shown and described, the invention is not limited to the above embodiments and may be embodied in other specific forms without departing from the essential characteristics thereof.

### Reference Signs List

- 1: Heat exchanger
- 2: Main body
- 3: Passage
- 6: Heat spreader
- 7: Semiconductor device
- 10: Fin member
- 11: Fin
- 12: Base
- 13: Holding frame
- 14: Cover plate
- 23: Protrusion
- 50: Press device for cutting
- 60: Press device for forming protrusions
- 62: Die
- 63: Stopper
- 65: Punch

## Claims

1. A heat exchanger having a plurality of upstanding fins formed linearly and arranged in parallel with each other at predetermined intervals, and an upper plate and a lower plate placed top and bottom in an upstanding direction of the fins to enclose spaces between the adjacent fins to provide a plurality of passages defined by the enclosed spaces, wherein
at least one of the upper and lower plates includes a plurality of protrusions arranged in a longitudinal direction of each passage to protrude therein.

2. The heat exchanger according to claim 1 having: a fin member including the fins integrally formed on a base constituting either one of the upper and lower plates; and a cover plate constituting the other one of the upper and lower plates which is connected to the fins in an opposite side from the base, wherein
the protrusions are formed on either the base or the cover plate.

3. The heat exchanger according to claim 2, wherein
the fin member is formed by extrusion-molding.

4. The heat exchanger according to claim 3, wherein
the protrusions are formed by press working.

5. The heat exchanger according to one of claims 1 to 4, wherein
ones of the protrusions adjacently arranged in a longitudinal direction of each passage are placed at such intervals as to prevent cooling performance to be generated between the protrusions from falling below a predetermined reference value.

6. The heat exchanger according to one of claims 1 to 5, wherein
the protrusions formed in the adjacent passages are arranged in a staggered pattern in a direction perpendicular to the passages.

7. A method for manufacturing a heat exchanger including a plurality of upstanding fins formed linearly and arranged in parallel with each other at predetermined intervals and an upper plate and a lower plate placed top and bottom in an upstanding direction of the fins to enclose spaces between the adjacent fins to provide a plurality of passages defined by the enclosed spaces, wherein
the method comprises:
a fin member working step of forming a fin member by extrusion-molding, the fin member having a plurality of the fins upstanding vertically on a base constituting one of the upper and lower plates;
a protrusion forming step of forming a plurality of the protrusions by pressing on the base of the fin member or on a cover plate constituting the other one of the upper and lower plates; and
a bonding step of bonding the cover plate to the fins on an opposite side from the base.

8. The method for manufacturing a heat exchanger according to claim 7, wherein
the protrusion forming step comprises press-fitting a punch in the base or the cover plate on an opposite side from a passage surface to extrude a material toward the passage surface side.

9. The method for manufacturing a heat exchanger according to claim 8, wherein
when the protrusions are to be formed in the base in the protrusion forming step, a plate-shaped holding member is inserted in the spaces between the adjacent fins to hold the fins.

10. The method for manufacturing a heat exchanger according to claim 7, wherein
the fin member working step includes forming a fin member having raised portions each continuous in the extruding direction in each space between the adjacent fins, and
the protrusion forming step includes inserting pressing plates separately formed in the extruding direction into the spaces to squash the raised portions except separating portions to form the protrusions.
